# EUROPEAN PATENT APPLICATION

(11) **EP 3 358 623 A1**
(43) Date of publication of application: **08.08.2018**
(21) Application number: 18150955.5
(22) Date of filing: 10.01.2018
(51) Int. Cl.: H01L 27/146

(54) **IMAGE SENSOR**

(30) Priority: 01.02.2017 JP 2017017152; 28.11.2017 JP 2017227723
(71) Applicant: Renesas Electronics Corporation, Tokyo 135-0061 (JP)
(72) Inventor: Murao, Fumihide, Tokyo, 135-0061 (JP); Shida, Koji, Tokyo, 135-0061 (JP)
(74) Representative: Betten & Resch

(57) **Abstract**

In a related image sensor, here is a problem that the SN ratio of the image signal becomes unstable. According to one exemplary embodiment, an image sensor includes a first chip A and a second chip B configured to transmit and receive signals to and from the first chip through a micro-bump, the first chip being stacked on top of the second chip, wherein on the first chip, pixel circuits 31 - 3n are arranged in a lattice structure, each of the pixel circuits including a photoelectric conversion element 41, a transfer transistor 42, a reset transistor 43, and an amplification transistor 44, and on the second chip, at least an input stage circuit COMP of an analog-to-digital converter circuit configured to convert a dark level signal and an imaging signal output from the pixel circuits 31 - 3n into a digital value is formed, and the number of input stage circuits COMP is at least two times the number of lines of the pixel circuits.

## Description

### BACKGROUND

The present invention relates to an image sensor and, for example, relates to an image sensor having a structure in which a plurality of chips are stacked together.

In an image sensor that converts optical information into image data in a camera or the like, photoelectric conversion elements are arranged in a lattice structure. Types of image sensors include rolling shutter and global shutter. The rolling shutter image sensor performs exposure and imaging signal readout with a certain time delay in each line. In the rolling shutter image sensor, because imaging is done in one line at a time, if an image of a subject moving at high speed is taken, a rolling distortion where an image is obliquely distorted occurs. On the other hand, the global shutter image sensor performs exposure simultaneously on all photoelectric conversion elements, and reads an imaging signal generated by this exposure. Thus, a rolling distortion does not occur in the global shutter type. An example of an image sensor that employs global shutter technology is disclosed in the specification of Japanese Patent No. 4835710.

The solid-state image sensor device disclosed in Japanese Patent No. 4835710 has a structure in which a first substrate on which a photoelectric conversion unit is formed and a second substrate on which a charge accumulation capacitor unit and a plurality of MOS transistors are formed are bonded together. Further, connection electrodes are formed on each of the first substrate and the second substrate, and the first substrate and the second substrate are electrically connected by the connection electrodes. Thus, according to the solid-state image sensor device disclosed in Japanese Patent No. 4835710, it is possible to form a solid-state image sensor device having a global shutter function in a smaller area.

### SUMMARY

However, the image sensor disclosed in Japanese Patent No. 4835710 has a problem that the potential of an imaging signal becomes unstable in the process of extracting the imaging signal from the photoelectric conversion unit and converting the imaging signal into image data, or the quality of obtained image data is degraded due to noise that is mixed into the signal.

The other problems and novel features of the present invention will become apparent from the description of the specification and the accompanying drawings.

According to one exemplary embodiment, an image sensor includes a first chip and a second chip configured to transmit and receive signals to and from the first chip through a micro-bump, the first chip being stacked on top of the second chip, wherein on the first chip, pixel circuits are arranged in a lattice structure, each of the pixel circuits including a photoelectric conversion element, a transfer transistor, a reset transistor, and an amplification transistor, and on the second chip, at least an input stage circuit of an analog-to-digital converter circuit configured to convert a dark level signal and an imaging signal output from the pixel circuit into a digital value is formed, and the number of input stage circuits is at least two times the number of lines of the pixel circuits.

According to the exemplary embodiment described above, it is possible to achieve a global shutter image sensor that generates high-quality image data.

### BRIEF DESCRIPTION OF THE DRAWINGS

The above and other aspects, advantages and features will be more apparent from the following description of certain embodiments taken in conjunction with the accompanying drawings, in which:
Fig. 1 is a block diagram of a camera system according to a first exemplary embodiment;
Fig. 2 is a schematic diagram of a part of the floor layout of the image sensor according to the first exemplary embodiment;
Fig. 3 is a block diagram of the image sensor according to the first exemplary embodiment;
Fig. 4 is a view showing one example of the individual analog-to-digital converter circuit and the operation thereof in the image sensor according to the first exemplary embodiment;
Fig. 5 is a view illustrating another example of the individual analog-to-digital converter circuit and the operation thereof in the image sensor according to the first exemplary embodiment;
Fig. 6 is a timing chart illustrating the operation of the image sensor according to the first exemplary embodiment;
Fig. 7 is a timing chart illustrating a difference between the operation of the image sensor according to the first exemplary embodiment and the operation of the image sensor according to the comparative example;
Fig. 8 is a block diagram for explaining first example of the image sensor according to the first exemplary embodiment;
Fig. 9 is a block diagram for explaining second example of the image sensor according to the first exemplary embodiment;
Fig. 10 is a timing chart illustrating another example of the operation of the image sensor 15 according to the first exemplary embodiment;
Fig. 11 is a block diagrams showing first examples of the image sensor according to the second exemplary embodiment;
Fig. 12 is a block diagrams showing second examples of the image sensor according to the second exemplary embodiment;
Fig. 13 is a block diagrams showing third examples of the image sensor according to the second exemplary embodiment
Fig. 14 is a block diagram of a first example of the image sensor according to the third exemplary embodiment;
Fig. 15 is a block diagram of a second example of the image sensor according to the third exemplary embodiment;
Fig. 16 is a block diagram of the image sensor 15 according to the fourth exemplary embodiment;
Fig. 17 is a block diagram illustrating a first example of a pixel circuit in the image sensor according to the fifth exemplary embodiment;
Fig. 18 is a block diagram illustrating a second example of a pixel circuit in the image sensor according to the fifth exemplary embodiment;
Fig. 19 is a block diagram of the image sensor according to the sixth exemplary embodiment;
Fig. 20 is a block diagram of the image sensor according to the seventh exemplary embodiment;
Fig. 21 is a layout example corresponding to the image sensor shown in Fig. 3;
Fig. 22 is a layout example corresponding to the image sensor shown in Fig. 14;
Fig. 23 is a layout example corresponding to the image sensor shown in Fig. 19;
Fig. 24 is a block diagram of the image sensor according to the eighth exemplary embodiment;
Fig. 25 is the timing chart illustrating the operation of the image sensor according to the eighth exemplary embodiment;
Fig. 26 is a block diagram of the image sensor according to the ninth exemplary embodiment; and
Fig. 27 is a timing chart illustrating the operation of the image sensor according to the ninth exemplary embodiment.

### DETAILED DESCRIPTION

### First exemplary embodiment

The following description and the attached drawings are appropriately shortened and simplified to clarify the explanation. In the figures, the identical reference symbols denote identical structural elements and the redundant explanation thereof is omitted.

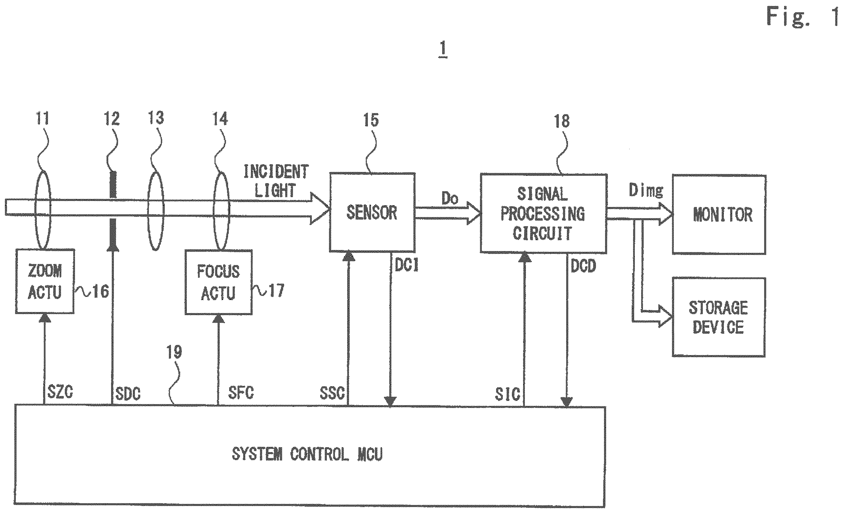

Fig. 1 is a block diagram of a camera system 1 according to a first exemplary embodiment. As shown in Fig. 1, the camera system 1 includes a zoom lens 11, a diaphragm mechanism 12, a fixed lens 13, a focus lens 14, an image sensor 15, a zoom lens actuator 16, a focus lens actuator 17, a signal processing circuit 18, a system control MCU 19, a monitor, and a storage unit. The monitor and the storage unit are to check and store images taken by the camera system 1, and they may be placed in another system separated from the camera system 1.

The zoom lens 11, the diaphragm mechanism 12, the fixed lens 13 and the focus lens 14 form a lens group of the camera system 1. The position of the zoom lens 11 is changed by the zoom actuator 16. The position of the focus lens 14 is changed by the focus actuator 17. The camera system 1 changes the zoom magnification and focus by moving the lenses using the respective actuators and changes the amount of incident light by the operation of the diaphragm mechanism 12.

The zoom actuator 16 moves the zoom lens 11 based on a zoom control signal SZC that is output from the system control MCU 19. The focus actuator 17 moves the focus lens 14 based on a focus control signal SFC that is output from the system control MCU 19. The diaphragm mechanism 12 adjusts the f-number by a diaphragm control signal SDC that is output from the system control MCU 19.

The image sensor 15 includes a photoelectric conversion element (which is referred to hereinafter as a photoreceptor) such as a photodiode, for example, and converts photoreceptor pixel information that is obtained from the photoreceptor into a digital value and outputs image information Do. Further, the image sensor 15 analyzes the image information Do that is output from the image sensor 15 and outputs image feature information DCI representing the feature of the image information Do. The image feature information DCI contains two images that are acquired by autofocus processing, which is described later. Furthermore, the image sensor 15 performs gain control of each pixel of the image information Do, exposure control of the image information Do, and HDR (High Dynamic Range) control of the image information Do based on a sensor control signal SSC that is supplied from the system control MCU 19. The image sensor 15 is described in detail later.

The signal processing circuit 18 performs image processing such as image correction on the image information Do that is received from the image sensor 15 and outputs image data Dimg. The signal processing circuit 18 analyzes the received image information Do and outputs color space information DCD. The color space information DCD contains luminance information and color information of the image information Do, for example.

The system control MCU 19 controls the focus of the lens group based on the image feature information DCI that is output from the image sensor 15. To be specific, the system control MCU 19 outputs the focus control signal SFC to the focus actuator 17 and thereby controls the focus of the lens group. The system control MCU 19 outputs the diaphragm control signal SDC to the diaphragm mechanism 12 and thereby adjusts the f-number of the diaphragm mechanism 12. Further, the system control MCU 19 generates the zoom control signal SZC according to a zoom instruction that is supplied from the outside and outputs the zoom control signal SZC to the zoom actuator 16, and thereby controls the zoom magnification of the lens group.

To be more specific, the focus is displaced by moving the zoom lens 11 using the zoom actuator 16. The system control MCU 19 calculates a positional phase difference between two object images based on two images contained in the image feature information DCI that is obtained from the image sensor 15, and calculates the amount of defocus of the lens group based on the positional phase difference. The system control MCU 19 automatically achieves focus according to the amount of defocus. This processing is called autofocus control.

Further, the system control MCU 19 calculates an exposure control value that instructs exposure setting of the image sensor 15 based on luminance information contained in the color space information DCD that is output from the signal processing circuit 18, and controls exposure setting and gain setting of the image sensor 15 so that the luminance information contained in the color space information DCD that is output from the signal processing circuit 18 is close to the exposure control value. At this time, the system control MCU 19 may calculate a control value of the diaphragm mechanism 12 when changing the exposure.

Further, the system control MCU 19 outputs a color space control signal SIC for adjusting the luminance or color of the image data Dimg based on an instruction from a user. Note that the system control MCU 19 generates the color space control signal SIC based on a difference between the color space information DCD that is acquired from the signal processing circuit 18 and information that is supplied from the user.

One feature of the camera system 1 according to the first exemplary embodiment is a control method when reading pixel information from a photodiode in the image sensor 15. The image sensor 15 is described in detail hereinbelow.

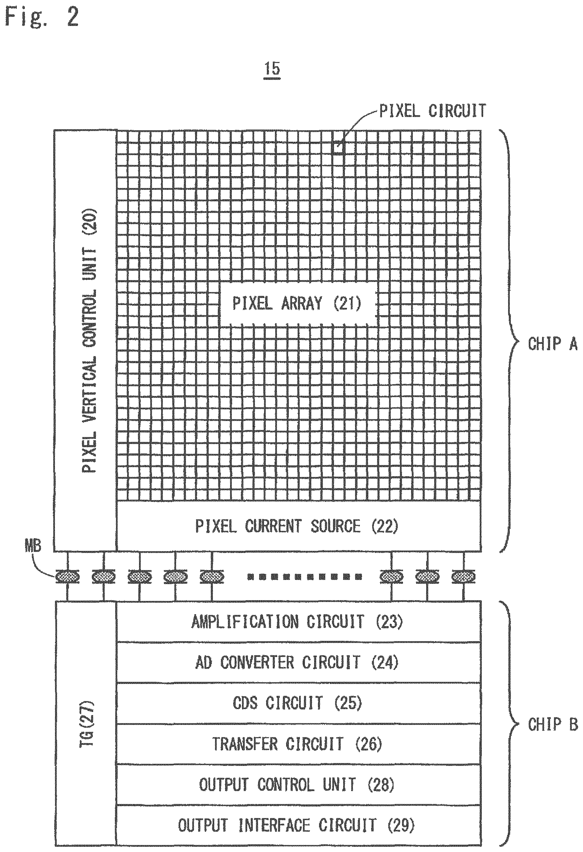

Fig. 2 is a schematic diagram of a part of the floor layout of the image sensor according to the first exemplary embodiment. Fig. 2 shows only the floor layout of a pixel vertical control unit 20, a pixel array 21, a pixel current source 22, an amplification circuit 23, an analog-to-digital converter circuit 24, a subtraction circuit (e.g., CDS (Correlated Double Sampling) circuit) 25, a transfer circuit 26, a timing generator 27, an output control unit 28, and an output interface 29, which is a part of the floor layout of the image sensor 15.

Further, as shown in Fig. 2, the image sensor 15 according to the first exemplary embodiment are composed of two chips. In the image sensor 15 according to the first exemplary embodiment, the pixel vertical control unit 20, the pixel array 21 and the pixel current source 22 are placed on a first chip (e.g., chip A). Further, on a second chip (e.g., chip B), the amplification circuit 23, the analog-to-digital converter circuit 24, the CDS circuit 25, the transfer circuit 26, the timing generator 27, the output control unit 28 and the output interface 29 are placed. The image sensor 15 according to the first exemplary embodiment has a structure in which the first chip is stacked on top of the second chip. Further, in the image sensor 15 according to the first exemplary embodiment, the first chip and the second chip are connected by micro-bumps, and signals are transmitted and received between the first chip and the second chip via the micro-bumps.

The pixel vertical control unit 20 controls the operation of pixel circuits that are arranged in a lattice structure on the pixel array 21 for each line. The pixel current source 22 has a current source that is placed for each of the pixel circuits arranged on the pixel array 21. The amplification circuit 23 performs amplification and gain adjustment of signals that are read from the pixel circuits. The analog-to-digital converter circuit 24 converts the signals after gain adjustment by the amplification circuit 23 into digital values. The CDS circuit 25 outputs, as a pixel value, a difference value between a dark level value corresponding to a dark level signal that is obtained when resetting the floating diffusion in the pixel circuit and a pixel value corresponding to a signal level of an imaging signal that is output from the pixel circuit in accordance with the amount of light received. The pixel value that is output from the CDS circuit 25 serves as pixel information. By the CDS circuit 25, noise that is superimposed on the imaging signal is removed. The transfer circuit 26 transfers the pixel information from which noise is removed by the CDS circuit 25 to the output control unit 28, sequentially in the order of distance from the output control unit 28 from shortest to longest. The timing generator 27 controls the operation timing of the pixel vertical control unit 20, the pixel current source 22, the amplification circuit 23, the AD converter circuit 24, and the CDS circuit 25. The output control unit 28 outputs the pixel information transferred by the horizontal transfer circuit 26 to the output interface 29. The output interface 29 is an output interface circuit of the image sensor 15.

One feature of the image sensor 15 according to the first exemplary embodiment is which circuits are to be placed on each of the chip A and the chip B. The image sensor 15 is described hereinafter in detail.

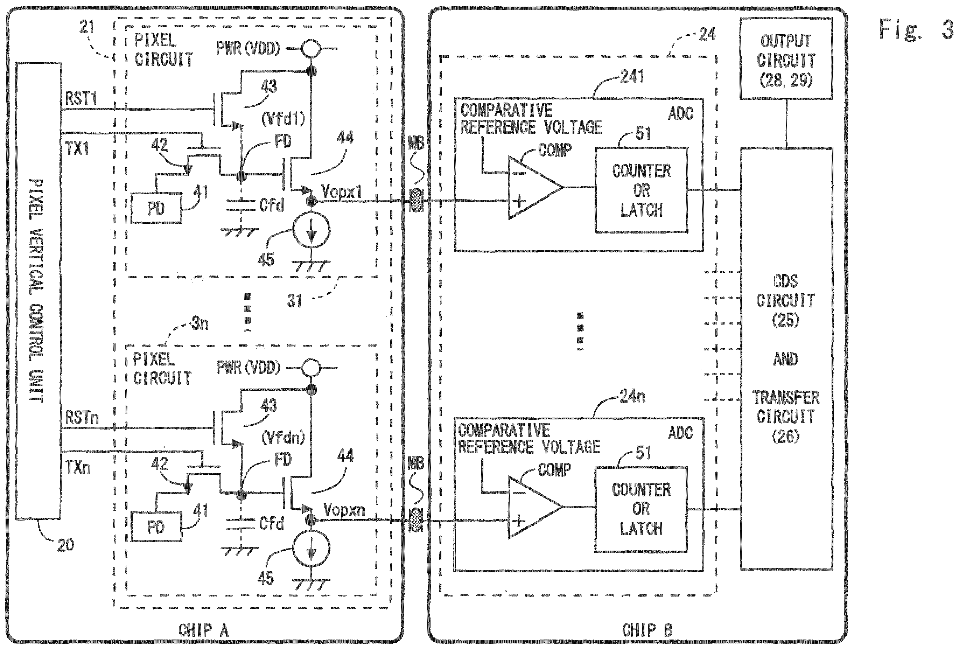

Fig. 3 is a block diagram of the image sensor 15 according to the first exemplary embodiment. As shown in Fig. 3, in the image sensor 15 according to the first exemplary embodiment, the pixel vertical control unit 20 and the pixel array 21 are formed on the chip A. Further, the pixel current source 22 shown in Fig. 2 is incorporated, as a constant current source 45, into a pixel circuit 31 placed in the pixel array 21. As shown in Fig. 3, the constant current source 45 is placed for each pixel circuit in the image sensor 15 according to the first exemplary embodiment.

Further, as shown in Fig. 3, in the image sensor 15 according to the first exemplary embodiment, the analog-to-digital converter circuit 24, the CDS circuit 25, the transfer circuit 26, the output control unit 28 and the output interface 29 are placed on the chip B. Note that, although the illustration of the analog-to-digital converter circuit 24 and the timing generator 27 is omitted in Fig. 3, those circuits are also placed on the chip B. Further, in the example shown in Fig. 3, an input stage circuit that is placed on the chip B is a comparator COMP which is placed inside the analog-to-digital converter circuit 24 and to which a pixel signal Vopx is input. Note that the pixel signal Vopx includes a dark level signal corresponding to a reset voltage of a floating diffusion FD and an imaging signal corresponding to the amount of charge generated by exposure of a photodiode 41, and either one of the signals is used by a difference in operation timing.

As shown in Fig. 3, in the image sensor 15 according to the first exemplary embodiment, pixel signals Vopx1 to Vopxn that are output from the pixel circuits placed on the chip A are supplied to the analog-to-digital converter circuits 24 in the chip B via the micro-bumps MB.

The circuit structure of the image sensor 15 according to the first exemplary embodiment is described hereinafter in further detail. In the example shown in Fig. 3, n number (n is an integer indicating the number of pixel circuits) of pixel circuits 31 to 3n are placed on the pixel array 21. Each of the pixel circuits 31 to 3n includes a photoelectric conversion element (e.g., photodiode 41), a transfer transistor 42, a reset transistor 43, an amplification transistor 44, a constant current source 45, and a floating diffusion FD.

The photodiode 41 is a photoreceptor, and it generates electric charge in accordance with the amount of light received. The floating diffusion FD is a capacitor that temporarily accumulates the charge generated by the photodiode 41. The transfer transistor 42 is placed between the photodiode 41 and the floating diffusion FD. The transfer transistor 42 is controlled to be turned on or off by a read control signal X that is output from the pixel vertical control unit 20.

The reset transistor 43 is placed between a power supply line PWR and the floating diffusion FD, and a reset control signal RST is supplied to its gate. The reset transistor 43 is controlled to be turned on or off by the reset control signal RST. The reset transistor 43 supplies a reset voltage to the floating diffusion FD and the photodiode 41. In the image sensor 15 according to the first exemplary embodiment, the reset voltage is a power supply voltage.

The amplification transistor 44 has the drain connected to the power supply line PWR and the gate connected to the floating diffusion FD. The source of the amplification transistor 44 serves as an output terminal of the pixel circuit 31. Further, the constant current source 45 is placed between the source of the amplification transistor 44 and the ground line. The constant current source 45 serves as a load circuit of the amplification transistor 44.

The analog-to-digital converter circuit 24 is described hereinafter. In the example shown in Fig. 3, the image sensor 15 according to the first exemplary embodiment includes n number of individual analog-to-digital converter circuits 241 to 24n within the analog-to-digital converter circuit 24. Each of the individual analog-to-digital converter circuits 241 to 24n includes a comparator COMP, and a pixel signal Vopx is supplied to the comparator COMP. Thus, in the example shown in Fig. 3, the comparator COMP serves as the input stage circuit of the signal processing circuit for the pixel signal Vopx which is placed on the chip B. Further, the image sensor 15 according to the first exemplary embodiment includes n number of micro-bumps MB for the n number of pixel circuits. The number of individual analog-to-digital converter circuits included in the analog-to-digital converter circuit 24 is set to be the same as the number of micro-bumps placed corresponding to the pixel circuits, which is n.

Further, in the example shown in Fig. 3, the CDS circuit 25, the transfer circuit 26, the timing generator 27, the output control unit 28 and the output interface 29 are placed on the chip B, in addition to the individual analog-to-digital converter circuits 241 to 24n. Further, each of the individual analog-to-digital converter circuits 241 to 24n includes a digital value holding circuit 51. For the digital value holding circuit 51, a counter or a latch circuit is used in accordance with the circuit form of the individual analog-to-digital converter circuits 241 to 24n.

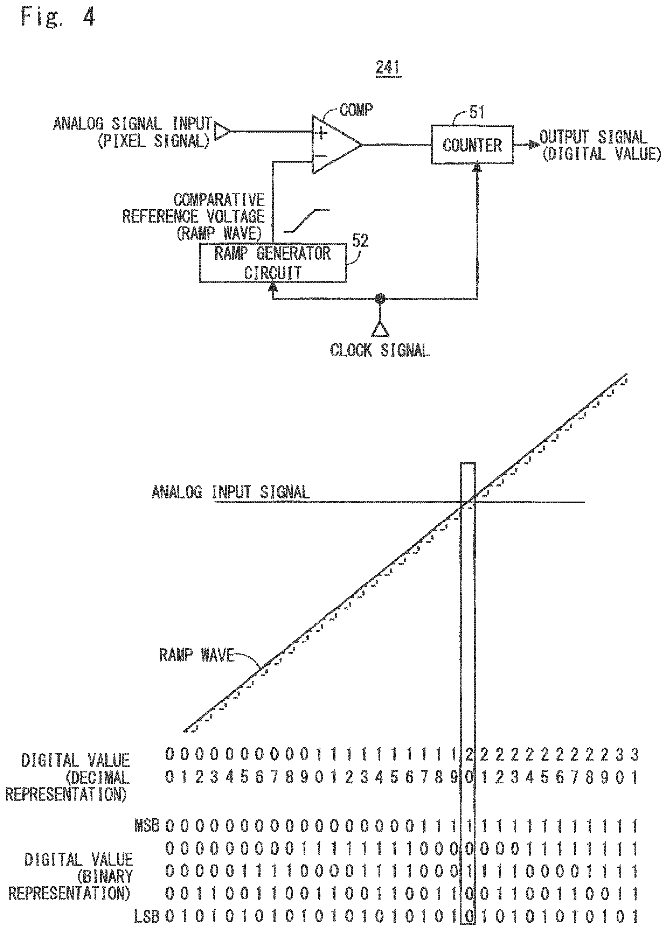

The individual analog-to-digital converter circuits 241 to 24n are described hereinafter in more detail. The individual analog-to-digital converter circuits 241 to 24n may have several types of circuit forms. The individual analog-to-digital converter circuit is described, using the individual analog-to-digital converter circuit 241 as an example. Fig. 4 is a view showing one example of the individual analog-to-digital converter circuit and the operation thereof in the image sensor according to the first exemplary embodiment. Fig. 4 shows a block diagram of the individual analog-to-digital converter circuit 241 in the upper part and shows a timing chart indicating the operation of the individual analog-to-digital converter circuit 241 in the lower part.

In the example shown in Fig. 4, the individual analog-to-digital converter circuit 241 includes a comparator COMP, a digital value holding circuit 51, and a ramp generator circuit 52. The ramp generator circuit 52 outputs a comparative reference voltage (e.g., ramp wave signal) whose value varies in accordance with a specified slope. Further, the ramp generator circuit 52 changes the voltage level of the ramp wave signal in accordance with a clock signal. The comparator COMP compares the comparative reference voltage with the pixel signal, and switches an output value from Low level to High level when the voltage level of the comparative reference voltage becomes higher than the voltage level of the pixel signal. The digital value holding circuit 51 is a counter, for example. The counter counts the number of clocks of the clock signal from the start of the analog-to-digital conversion process, and holds the count value when the output value of the comparator COMP becomes High level. The value held by the counter is the output value of the individual analog-to-digital converter circuit 241. In the example shown in Fig. 4, the voltage level of the ramp wave signal exceeds the voltage level of the pixel signal at the time when the count value reaches 20 in decimal representation, and therefore the digital value that is output from the individual analog-to-digital converter circuit 241 is "10100".

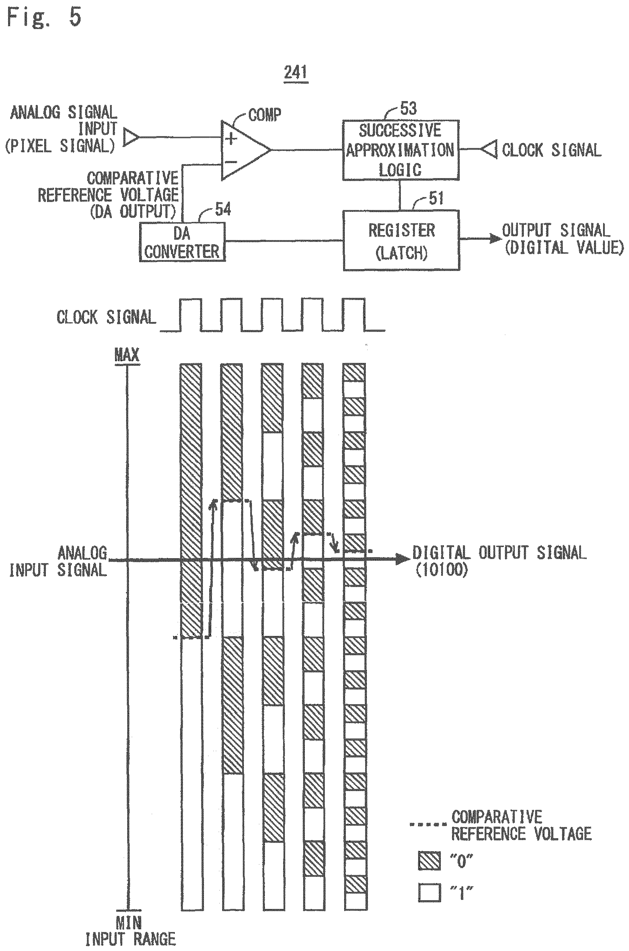

Fig. 5 shows a view illustrating another example of the individual analog-to-digital converter circuit and the operation thereof in the image sensor according to the first exemplary embodiment. Fig. 5 shows a block diagram of the individual analog-to-digital converter circuit 241 in the upper part and shows a timing chart indicating the operation of the individual analog-to-digital converter circuit 241 in the lower part.

In the example shown in Fig. 5, the individual analog-to-digital converter circuit 241 includes a comparator COMP, a digital value holding circuit 51, a successive approximation logic 53, and a digital-to-analog converter circuit 54. In this example, the digital value holding circuit 51 is a latch circuit. The digital-to-analog converter circuit 54 outputs a comparative reference voltage with a voltage level corresponding to a digital value stored in the digital value holding circuit 51. The comparator COMP compares the comparative reference voltage with the voltage level of the pixel signal, and outputs Low level when the comparative reference voltage is higher than the voltage level of the pixel signal, and outputs High level when the comparative reference voltage is lower than the voltage level of the pixel signal. The successive approximation logic 53 updates the digital value stored in the register each time the output value of the comparator CMP is switched.

The example of Fig. 5 shows that the conversion process proceeds according to the clock signal, and the values stored in the latch circuit are determined sequentially from the high-order bit. It also shows that the comparative reference voltage that is output from the digital-to-analog converter circuit 54 varies depending on a conversion result in the previous conversion timing.

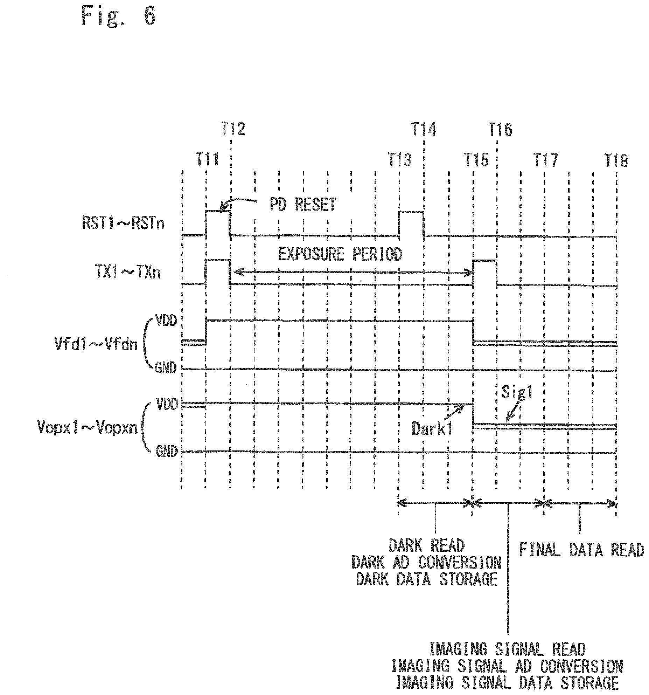

The operation of the image sensor 15 according to the first exemplary embodiment is described hereinafter. Fig. 6 shows a timing chart illustrating the operation of the image sensor according to the first exemplary embodiment. As shown in Fig. 6, in the image sensor 15 according to the first exemplary embodiment, the same control is carried out at the same timing for all pixels.

To be specific, in the period of the timing T11 to T12, a PD reset process is performed that sets both of the reset control signals RST1 to RSTn and the read control signals TX1 to TXn to High level and applies a reset voltage to the photodiode 41 and the floating diffusion FD to reset their potentials. Then, at the timing T12, both of the reset control signals RST1 to RSTn and the read control signals TX1 to TXn are set to Low level, thereby isolating the photodiode 41 from the floating diffusion FD and starting the exposure process.

Next, in the period of the timing T13 to T14, the reset control signals RST1 to RSTn are switched to High level, and the floating diffusion FD is reset to the reset voltage. Further, in the period of the timing T13 to T15, the reset voltage of the floating diffusion FD is read as a dark level signal, and analog-to-digital conversion on the dark level signal and storing of data of the dark level signal are performed.

Then, in the period of the timing T15 to T16, the read control signals TX1 to TXn are switched to High level, and charge is transferred and read from the photodiode 41 to the floating diffusion FD. Further, in the period of the timing T15 to T17, a pixel signal that is generated based on the charge transferred to the floating diffusion FD is read, and analog-to-digital conversion on this pixel signal and storing of data of the pixel signal are performed.

After that, in the period of the timing T17 to T18, a difference between the data of the dark level signal and the data of the imaging signal is calculated, and pixel information, which serves as final pixel data, is read.

In the image sensor 15 according to the first exemplary embodiment having the above-described circuit structure, it is possible to enhance the SN (Signal-Noise) radio of pixel information of an image and improve the image quality, employing the global shutter technology.

In the image sensor disclosed in Japanese Patent No. 4835710, the photodiode 41 and the transfer transistor 42 of the pixel circuit shown in Fig. 3 are placed on the first chip, and the floating diffusion FD, the reset transistor 43, and the amplification transistor 44 are placed on the second chip. Further, when transferring charge from the first chip to the second chip, the charge generated in the photodiode 41 is temporarily accumulated in a charge holding capacitor placed on the second chip and then transferred to the floating diffusion FD.

Thus, in the image sensor disclosed in Japanese Patent No. 4835710, the source (diffusion region) of the transfer transistor 42 is always subjected to light, and therefore charge that is generated in the source of the transfer transistor 42 due to incident light is further accumulated in the charge holding capacitor after the transfer of charge to the charge holding capacitor. Therefore, in the image sensor disclosed in Japanese Patent No. 4835710, a larger amount of charge than the charge generated by the photodiode 41 is accumulated in the charge holding capacitor, and the imaging signal that is output from a pixel circuit has a higher voltage than the voltage corresponding to the exposure amount of the photodiode 41. This voltage deviation in the imaging signal becomes noise that remains even after eliminating the dark level signal.

Further, in the image sensor disclosed in Japanese Patent No. 4835710, because the charge holding capacitor is connected to the gate of the amplification transistor at the time of outputting the imaging signal, the charge holding capacitance and the parasitic capacitance of the gate of the amplification transistor are combined when outputting the imaging signal, and the capacitance value of the capacitor in which the charge to serve as the imaging signal is accumulated varies before and after the output of the imaging signal. Therefore, in the image sensor disclosed in Japanese Patent No. 4835710, a variation occurs in the voltage that is generated due to the charge accumulated in the charge holding capacitor varies, and the voltage variation is input to the amplification transistor and output from the drain as the imaging signal, which reduces the SN ratio of the imaging signal.

On the other hand, in the image sensor 15 according to the first exemplary embodiment, pixel circuits are placed on the chip A that is subjected to incident light, and a circuit that performs signal processing on the imaging signals that are output from the pixel circuits is placed on the chip B that is blocked from light. Specifically, the image sensor 15 according to the first exemplary embodiment converts the charge generated by the photodiode 41 in the chip A into the imaging signal, which is a voltage signal, by the amplification transistor that serves as a source follower circuit. Then, the image sensor 15 according to the first exemplary embodiment transmits the imaging signal, which is now the voltage signal, from the chip A to the chip B. Thus, the image sensor 15 according to the first exemplary embodiment can make conversion into the imaging signal having the voltage corresponding to the amount of charge of the floating diffusion FD before the amount of charge of the floating diffusion FD varies due to incident light. Further, in the image sensor 15 according to the first exemplary embodiment, processing on the imaging signal is performed on the chip B which is not affected by incident light. In this circuit structure, the image sensor 15 according to the first exemplary embodiment can employ the global shutter technology and obtain the imaging signal and the pixel information with no degradation of the SN ratio.

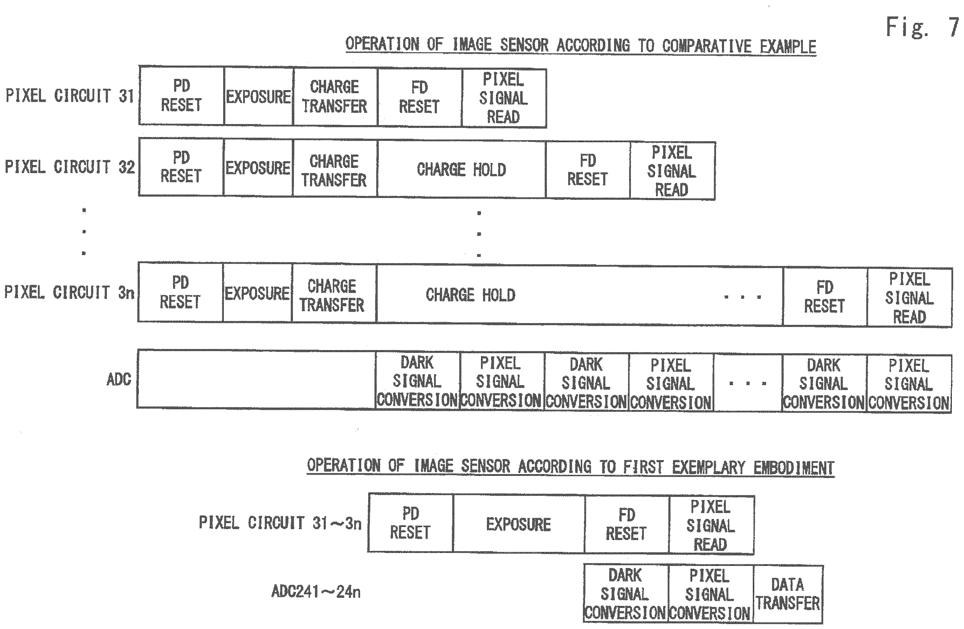

The operation of the image sensor 15 according to the first exemplary embodiment is described hereinafter in comparison to the operation of the image sensor disclosed in Japanese Patent No. 4835710 as a comparison example. Fig. 7 shows a timing chart illustrating a difference between the operation of the image sensor 15 according to the first exemplary embodiment and the operation of the image sensor according to the comparative example. As shown in Fig. 7, in the image sensor according to the comparative example, an exposure process and a transfer process that transfers the charge generated by the exposure to the charge holding capacitor are performed at a time on all pixels. However, in the image sensor according to the comparative example, generation of the imaging signal based on the charge stored in the charge holding capacitor and analog-to-digital conversion on the imaging signal are sequentially performed in each line. This causes a problem that, as reading is done later, the voltage variation in the charge holding capacitance, which occurs due to the charge generated as a result that the source of the transfer transistor is subjected to light, increases.

On the other hand, in the image sensor 15 according to the first exemplary embodiment, a process from exposure to analog-to-digital conversion on the imaging signal is performed at a time on all pixels. Therefore, in the image sensor 15 according to the first exemplary embodiment, it is possible to avoid the imaging signal from being affected by the charge generated as a result that the source of the transfer transistor is subjected to light.

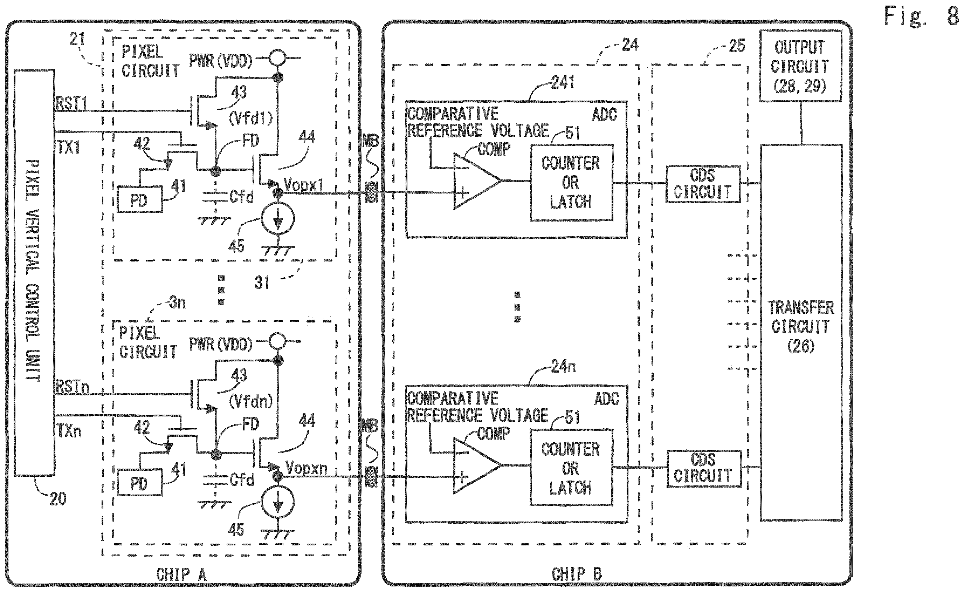

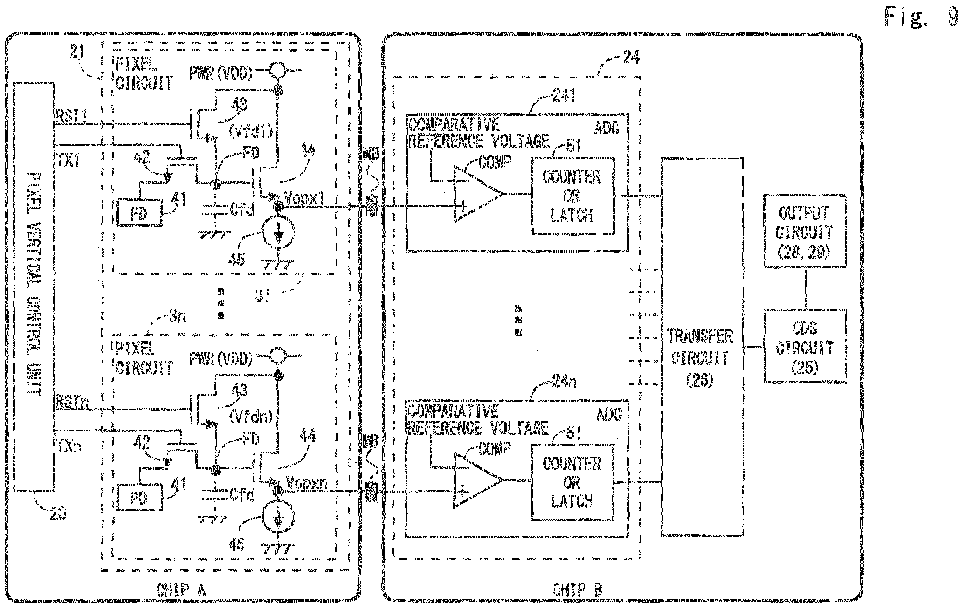

An example of the placement of the CDS circuit 25 in the image sensor 15 according to the first exemplary embodiment is described hereinafter. Although the CDS circuit 25 and the transfer circuit 26 are shown as one circuit block in the example described in Fig. 3, the CDS circuit 25 may be placed in any of the previous and subsequent stages of the transfer circuit 26. Fig. 8 is a block diagram of the image sensor 15 in which the CDS circuit 25 is placed in the previous stage of the transfer circuit 26, and Fig. 9 is a block diagram of the image sensor 15 in which the CDS circuit 25 is placed in the subsequent stage of the transfer circuit 26.

In the case where the CDS circuit 25 is placed in the previous stage of the transfer circuit 26, the CDS circuit 25 is placed for each of individual analog-to-digital converter circuits. In such placement, subtraction processing by the CDS circuit 25 is parallelizable, and it is thereby possible to increase the processing speed.

In the case where the CDS circuit 25 is placed in the subsequent stage of the transfer circuit 26, only one CDS circuit 25 is placed for n number of individual analog-to-digital converter circuits. In such placement, it is possible to reduce the circuit area needed for the CDS circuit 25.

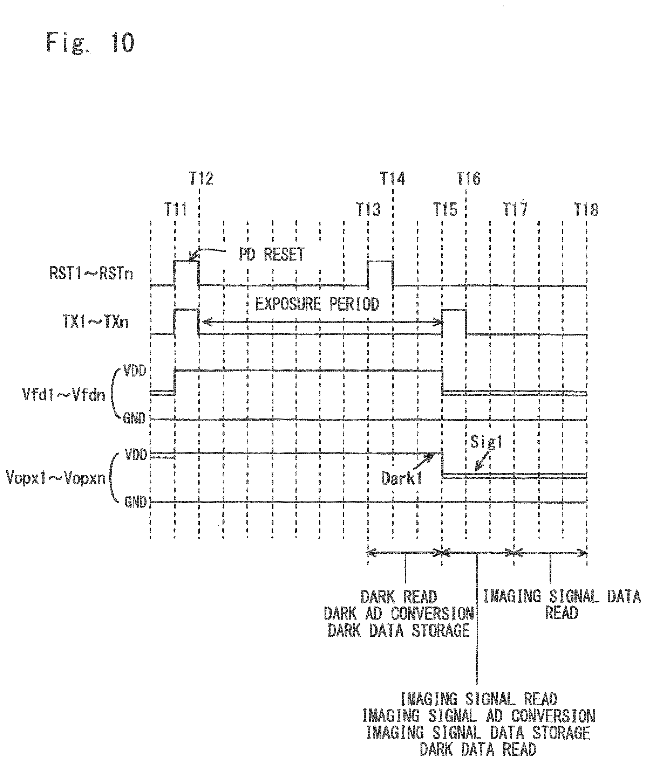

Further, another example of the operation of the image sensor 15 according to the first exemplary embodiment shown in Fig. 6 is described. Fig. 10 is a timing chart illustrating another example of the operation of the image sensor 15 according to the first exemplary embodiment. In the example shown in Fig. 10, the dark level signal that is stored in the digital value holding circuit 51 is transferred during the analog-to-digital conversion on the imaging signal. In this manner, by transferring the value that is stored in the digital value holding circuit 51 during the period of performing another processing, it is possible to increase the speed of processing and enhance the frame rate of the image sensor 15.

### Second exemplary embodiment

In a second exemplary embodiment, another example of the chip structure is described. Note that, in the description of the second exemplary embodiment, the same elements as those in the first exemplary embodiment are denoted by the same reference symbols as in the first exemplary embodiment and the description thereof is omitted.

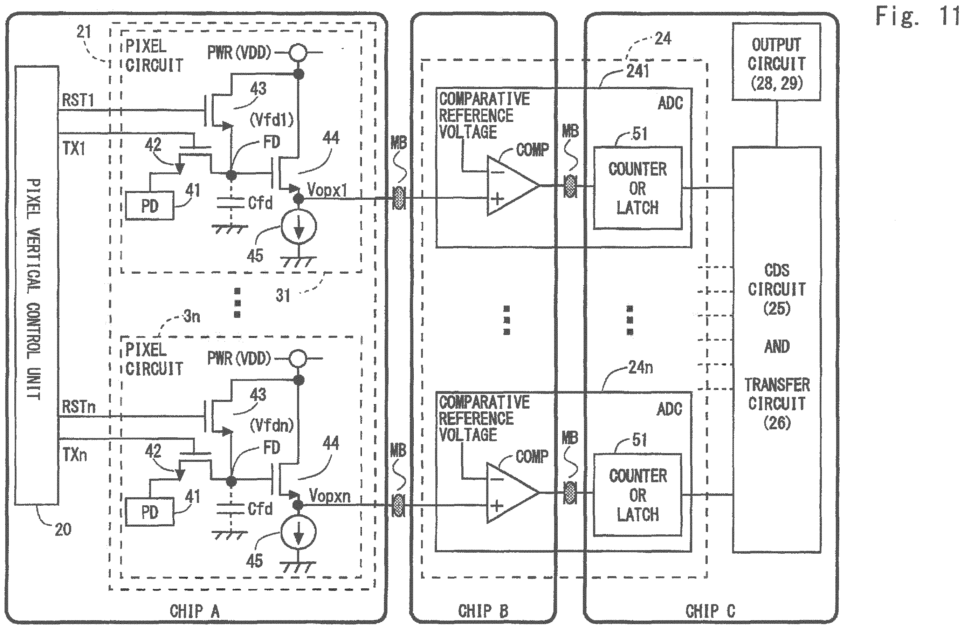

Figs. 11 to 13 are block diagrams showing first to third examples of the image sensor according to the second exemplary embodiment. In the first example shown in Fig. 11, the image sensor 15 is composed of three chips. As shown in Fig. 11, in the first example, the structure of a first chip (e.g., chip A) is the same as that of the first exemplary embodiment. On the other hand, in the first example, the input stage circuit including the comparator CMP of the individual analog-to-digital converter circuit is placed on a second chip (e.g., chip B), and the subsequent circuits of the comparator COMP excluding the input stage circuit are placed on a third chip (e.g., chip C).

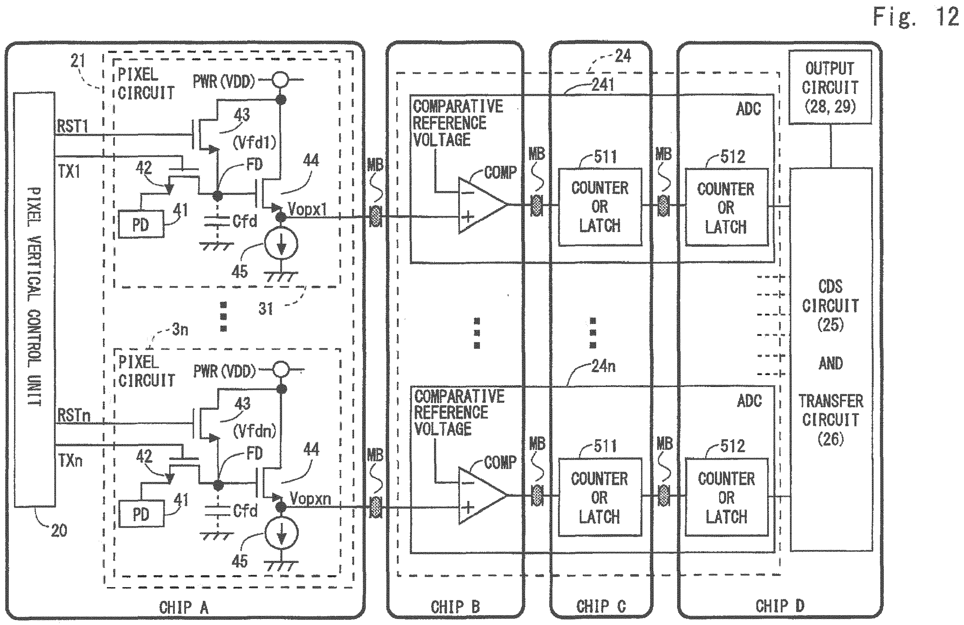

In the second example shown in Fig. 12, the image sensor 15 is composed of four chips. As shown in Fig. 12, in the second example, the digital value holding circuit 51 in the first example is divided into a digital value holding circuit 511 and a digital value holding circuit 512, and the digital value holding circuit 511 is placed on a third chip (e.g., chip C), and the digital value holding circuit 512 and the subsequent circuits are placed on a fourth chip (e.g., chip D).

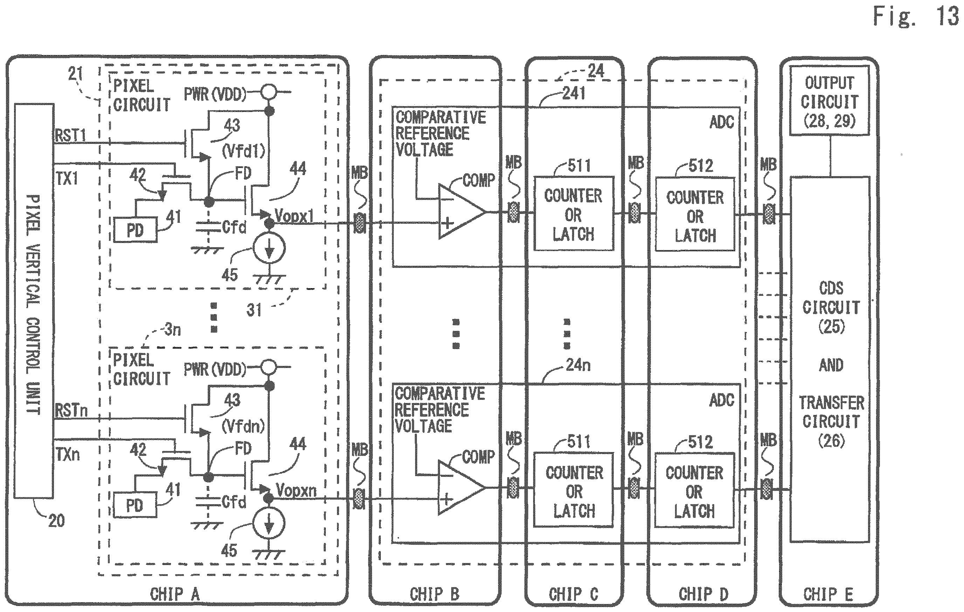

In the third example shown in Fig. 13, the image sensor 15 is composed of five chips. As shown in Fig. 13, in the third example, a circuit that is placed on the chip D of the second example is further divided. To be specific, the digital value holding circuit 512 is placed on a fourth chip (e.g., chip D), and the subsequent circuits of the digital value holding circuit 512 are placed on a fifth chip (e.g., chip E).

In this manner, by reducing a circuit unit to be mounted on one chip, it is possible to increase the number of pixel circuits to be placed on one chip and the number of processing circuits to be placed corresponding to the pixel circuits. Thus, by reducing a circuit unit that is mounted on one chip, it is possible to increase the number of pixels. In other words, by reducing a circuit unit to be mounted on one chip, it is possible to increase the number of pixels for the same chip area.

### Third exemplary embodiment

In a third exemplary embodiment, a modified example where the number of photoelectric conversion elements placed in one pixel circuit is increased is described. Note that, in the description of the third exemplary embodiment, the same elements as those in the first exemplary embodiment are denoted by the same reference symbols as in the first exemplary embodiment and the description thereof is omitted.

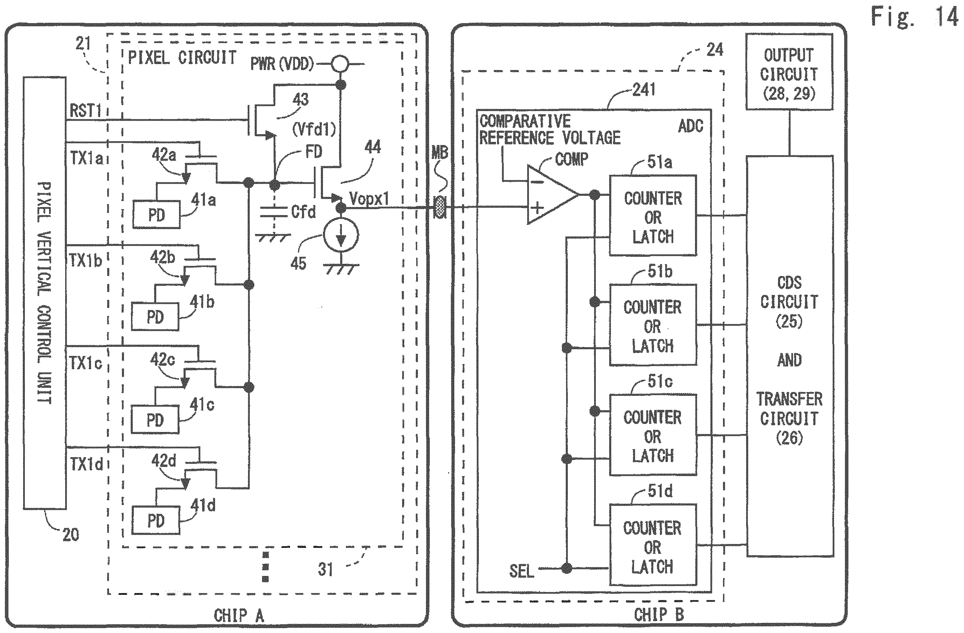

Fig. 14 is a block diagram of a first example of the image sensor according to the third exemplary embodiment. In the first example shown in Fig. 14, four photodiodes (photodiodes 41a to 41d in Fig. 14) are placed in one pixel circuit. To be specific, in the first example, four pairs of photodiodes and transfer transistors are connected in parallel to the floating diffusion FD in the pixel circuit.

Further, in the first example, four digital value holding circuits (e.g., digital value holding circuits 51a to 51b) corresponding to the photodiodes 41a to 41d are placed in each individual analog-to-digital converter circuit. In the first example of the image sensor 15 according to the third exemplary embodiment, four imaging signals that are generated by exposure of the photodiodes 41a to 41d are sequentially stored into the digital value holding circuits 51a to 51b.

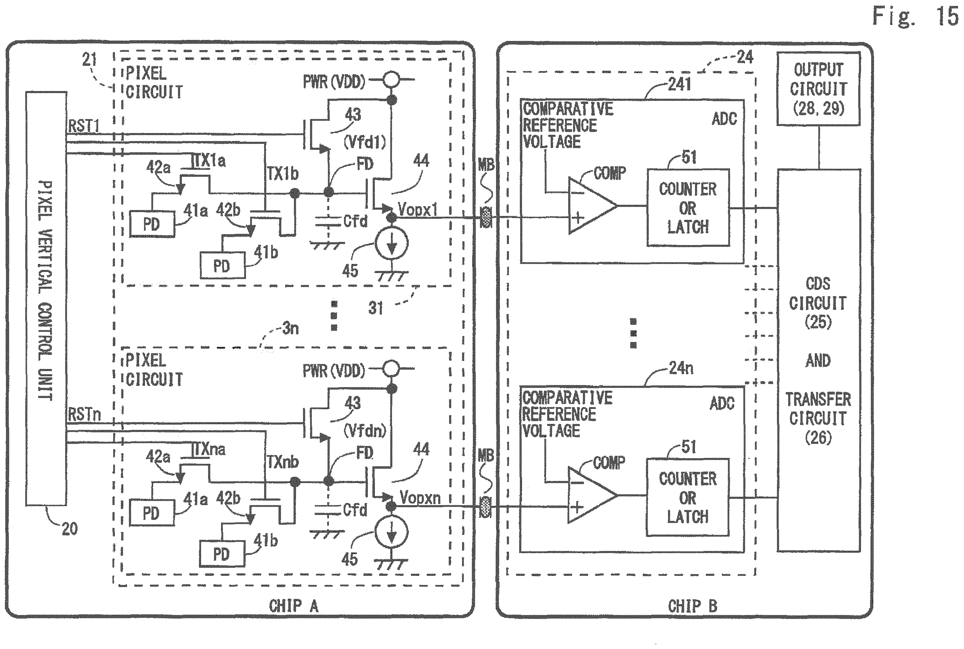

Fig. 15 is a block diagram of a second example of the image sensor according to the third exemplary embodiment. In the second example shown in Fig. 15, two photodiodes (photodiodes 41a and 41b in Fig. 15) are placed in one pixel circuit. To be specific, in the second example, two pairs of photodiodes and transfer transistors are connected in parallel to the floating diffusion FD in the pixel circuit.

On the other hand, in the second example, one digital value holding circuit 51 is placed in each individual analog-to-digital converter circuit, just like in the first exemplary embodiment. In the second example of the image sensor 15 according to the third exemplary embodiment, two imaging signals that are generated by exposure of the photodiodes 41a and 41b are sequentially stored into the digital value holding circuit 51 and also transferred to the subsequent circuit.

In the image sensor 15 according to the third exemplary embodiment, a plurality of photodiodes are placed for one set of the reset transistor 43, the amplification transistor 44 and the constant current source 45. Thus, in the image sensor 15 according to the third exemplary embodiment, the number of transistors in a pixel circuit which is required for one photodiode can be reduced. For example, the number of transistors per photodiode is 1.75 in the first example according to the third exemplary embodiment, and the number of transistors per photodiode is 2.5 in the second example. Further, in the second example, the circuit scale of the individual analog-to-digital converter circuit can be smaller than the circuit scale in the first example.

### Fourth exemplary embodiment

In a fourth exemplary embodiment, a modified example of the placement of the constant current source 45, which is placed as a load of the amplification transistor 44, is described. Note that, in the description of the fourth exemplary embodiment, the same elements as those in the first exemplary embodiment are denoted by the same reference symbols as in the first exemplary embodiment and the description thereof is omitted.

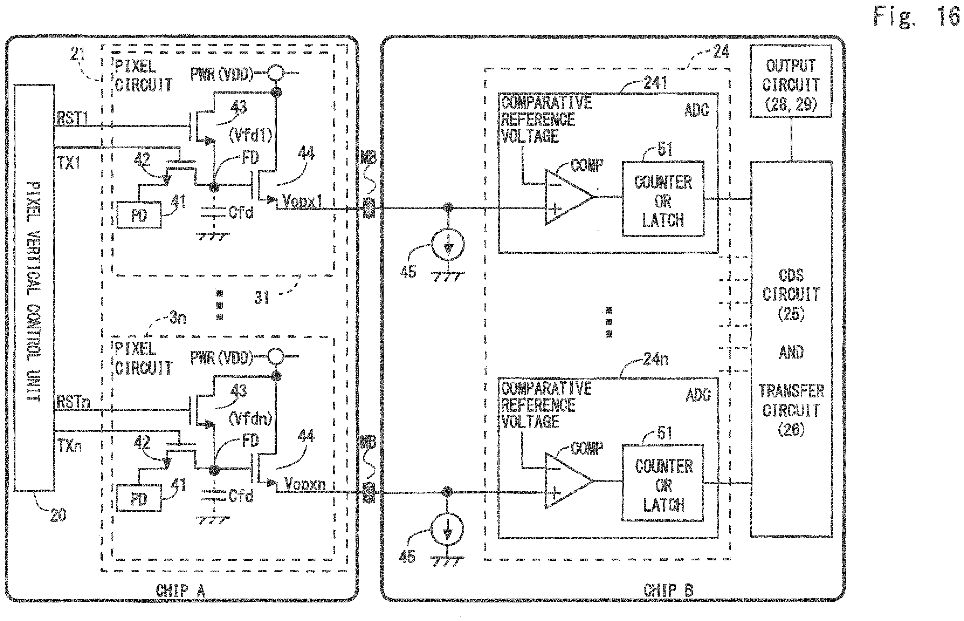

Fig. 16 is a block diagram of the image sensor 15 according to the fourth exemplary embodiment. As shown in Fig. 16, in the image sensor 15 according to the fourth exemplary embodiment, the constant current source 45 is placed on the second chip (e.g., chip B).

In the image sensor 15 according to the fourth exemplary embodiment, the constant current source 45 is placed on the chip B, and thereby the circuit area of the pixel circuits 31 to 3n can be smaller than that in the image sensor 15 according to the first exemplary embodiment. Thus, in the image sensor 15 according to the fourth exemplary embodiment, it is possible to increase the number of pixel circuits to be placed on the chip A. Note that, even when the constant current source 45 is placed on the chip B, the amount of current that is applied to the amplification transistor 44 does not change, and therefore the characteristics such as the SN ratio for the imaging signal do not change.

### Fifth exemplary embodiment

In a fifth exemplary embodiment, a modified example of the circuit structure in a pixel circuit is described. Note that, in the description of the fifth exemplary embodiment, the same elements as those in the first exemplary embodiment are denoted by the same reference symbols as in the first exemplary embodiment and the description thereof is omitted.

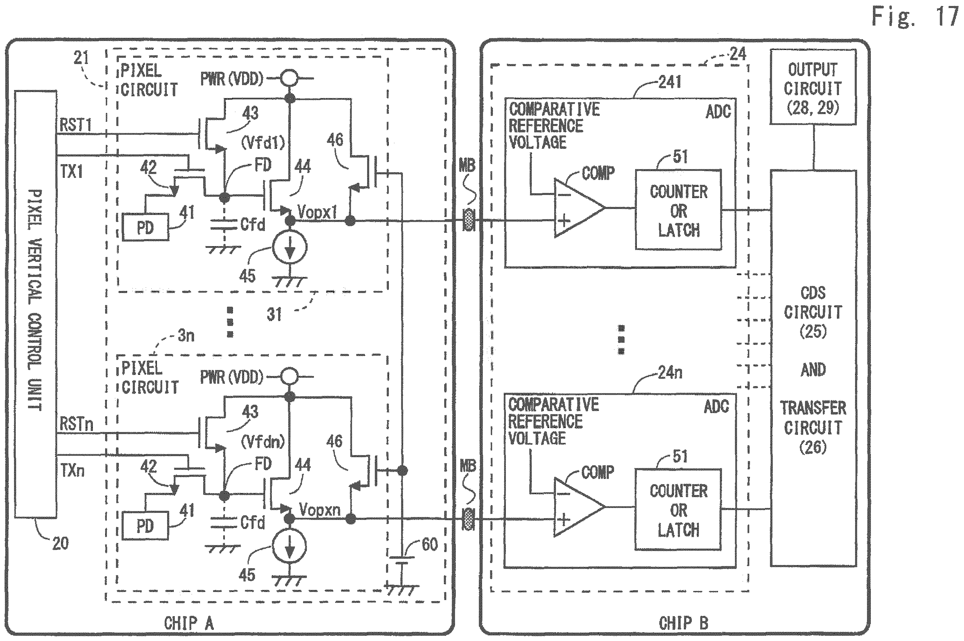

Fig. 17 is a block diagram illustrating a first example of a pixel circuit in the image sensor 15 according to the fifth exemplary embodiment. In the first example shown in Fig. 17, an output clamp transistor 46 is added to each of the pixel circuits 31 to 3n. The output clamp transistor 46A is supplied with a clamp setting voltage at its gate, and it is connected in parallel with the amplification transistor. Further, in the image sensor 15 according to the fifth exemplary embodiment, a voltage source 60 that outputs the clamp setting voltage is placed on the chip A.

The output clamp transistor 46 functions as a clipping circuit for pixel output. By placing such a clipping circuit, it is possible to suppress current variation in the current source of pixels and thereby reduce fixed pattern noise of pixels. Thus, in the first example of the image sensor 15 according to the fifth exemplary embodiment, it is possible to reduce fixed pattern noise.

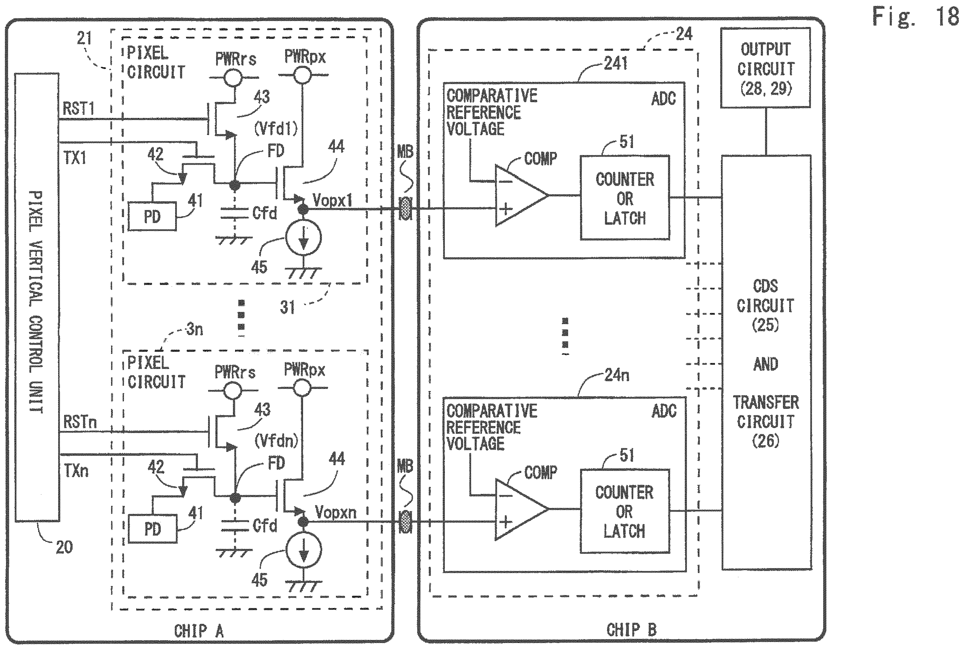

Fig. 18 is a block diagram illustrating a second example of a pixel circuit in the image sensor 15 according to the fifth exemplary embodiment. In the second example shown in Fig. 18, a reset voltage and a pixel power supply voltage to be applied to the drain of the amplification transistor 44 are supplied through lines that are independent of each other. In the example shown in Fig. 18, the reset voltage is applied to the drain of the reset transistor 43 through a reset power supply line PWRrs. Further, the pixel power supply voltage is applied to the drain of the amplification transistor 44 through a pixel power supply line PWRpx.

By supplying the pixel power supply voltage and the reset voltage through separate lines that are independent of each other, it is possible to make potential adjustment at the time of resetting the floating diffusion FD.

### Sixth exemplary embodiment

In a sixth exemplary embodiment, a modified example where one micro-bump MB and a circuit placed in the subsequent stage of the micro-bump MB are shared by a plurality of pixel circuits is described. Note that, in the description of the sixth exemplary embodiment, the same elements as those in the first exemplary embodiment are denoted by the same reference symbols as in the first exemplary embodiment and the description thereof is omitted.

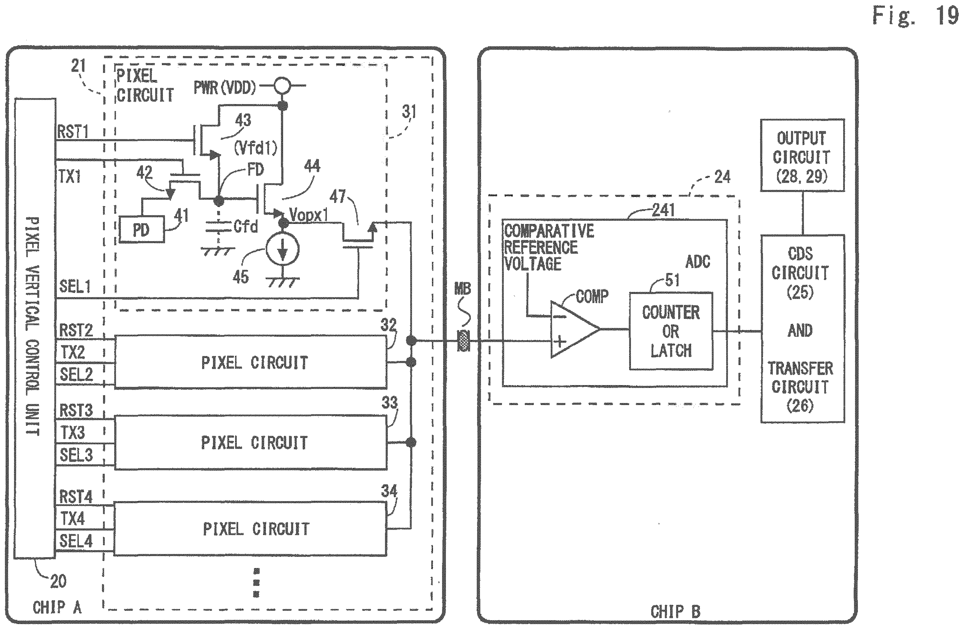

Fig. 19 is a block diagram of the image sensor 15 according to the sixth exemplary embodiment. In the example shown in Fig. 19, four pixel circuits (e.g., pixel circuits 31 to 34) are connected to one micro-bump MB. Further, the pixel circuit according to the sixth exemplary embodiment has a structure in which a selection transistor 47 is added to the pixel circuit according to the first exemplary embodiment. To be specific, the selection transistor 47 is placed between the amplification transistor 44 and the micro-bump MB. Further, a selection signal SEL is applied to the selection transistor 47. In the image sensor 15 according to the sixth exemplary embodiment, the individual analog-to-digital converter circuit 241 sequentially reads the dark level signal and the imaging signal from the pixel circuits 31 to 34, switching the pixel circuit from which the imaging signal is to be read by the selection transistor 47.

In the image sensor 15 according to the sixth exemplary embodiment, the micro-bump MB is shared by a plurality of pixel circuits, and it is thereby possible to reduce the number of micro-bumps MB. Further, in the image sensor 15 according to the sixth exemplary embodiment, the individual analog-to-digital converter circuit is shared by a plurality of pixel circuits, and it is thereby possible to reduce the circuit area of the individual analog-to-digital converter circuit per pixel circuit.

Further, in the image sensor 15 according to the third exemplary embodiment, a plurality of photodiodes are connected to the common amplification transistor 44. It is thus necessary that a plurality of photodiodes perform sequential reading, which arises a disadvantage that the exposure timing of each photodiode is not synchronized. However, in the image sensor 15 according to the sixth exemplary embodiment, the amplification transistor 44 is placed for each of a plurality of photodiodes, and the source of each amplification transistor 44 is connected to a common bump through the selection transistor. Therefore the image sensor 15 according to the sixth exemplary embodiment can operate without losing the synchronization of the exposure timing by controlling the transfer transistor 42 in the synchronized timing and sequentially reading the source voltage of each transistor by the selection transistor 47.

### Seventh exemplary embodiment

In a seventh exemplary embodiment, an example of circuit placement on the first chip and the second chip is described. Note that, in the description of the seventh exemplary embodiment, the same elements as those in the first exemplary embodiment are denoted by the same reference symbols as in the first exemplary embodiment and the description thereof is omitted.

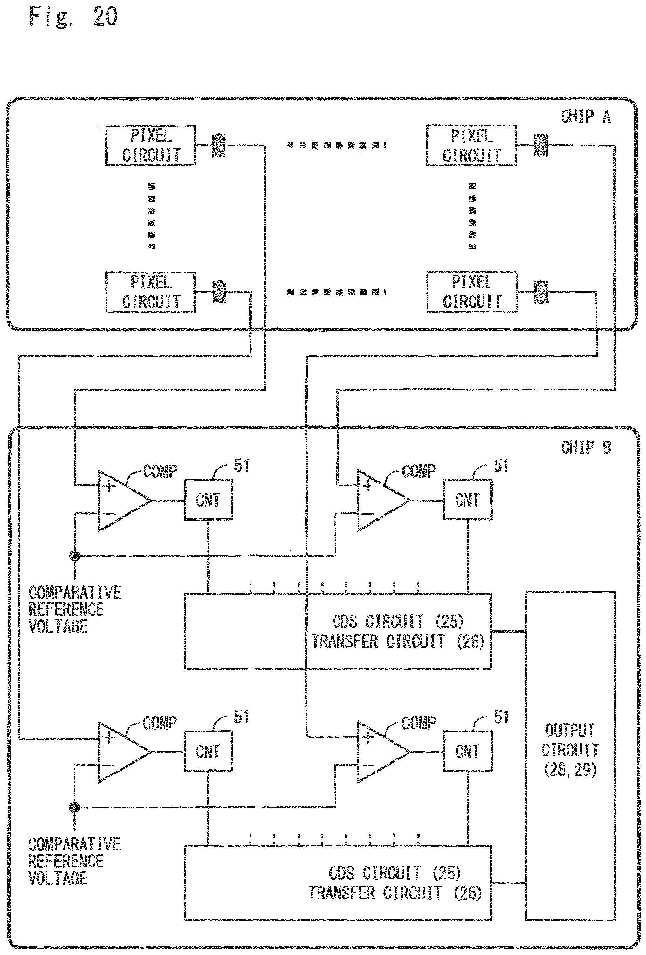

Fig. 20 is a block diagram of the image sensor 15 according to the seventh exemplary embodiment. As shown in Fig. 20, in the image sensor 15 according to the seventh exemplary embodiment, pixel circuits are arranged in a lattice structure on the first chip (e.g., chip A). Further, in the image sensor 15 according to the seventh exemplary embodiment, the micro-bump MB is placed for each of the pixel circuits.

Further, in the image sensor 15 according to the seventh exemplary embodiment, individual analog-to-digital converter circuits are arranged in a lattice structure on the second chip (e.g., chip B). Further, on the chip B, the CDS circuit 25 and the transfer circuit 26 are placed for each line of the individual analog-to-digital converter circuits arranged in a lattice structure. For all of the transfer circuits 26, the output control unit 28 and the output interface 29 are placed.

On the chip B, digital values that are generated by the individual analog-to-digital converter circuits are transferred horizontally by the transfer circuit 26, and the transferred digital values are sequentially transferred to the output circuit, and finally output to the outside from the output circuit.

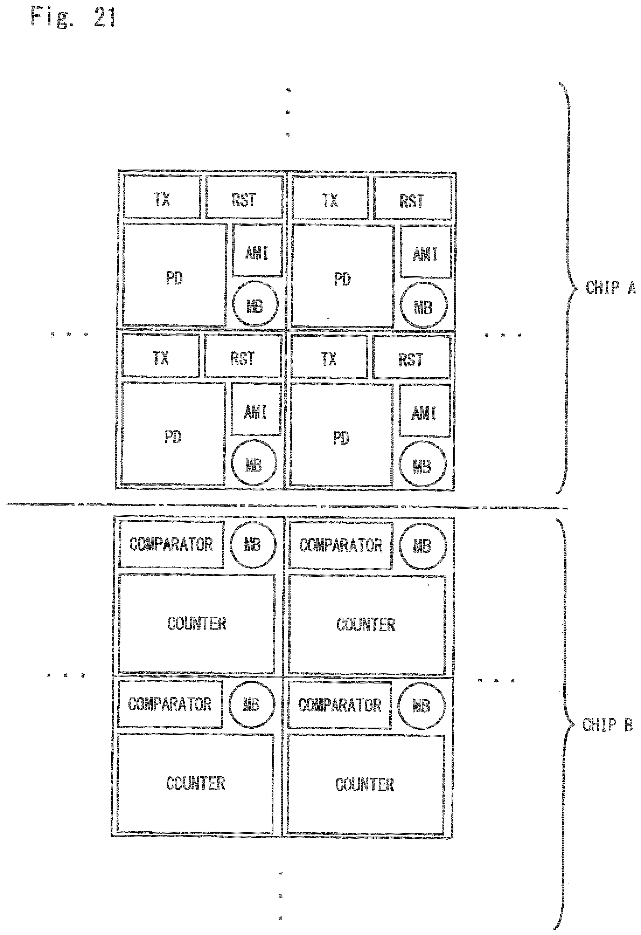

The layout of the pixel circuits placed on the chip A and the analog-to-digital converter circuits placed on the chip B is described. Note that, in Fig. 21 to Fig. 23, PD indicates a photodiode, TX indicates a transfer transistor, RST indicates a reset transistor, AMI indicates an amplification transistor, SEL indicates a selection transistor, and MB indicates a micro-bump.

Fig. 21 shows a layout example corresponding to the image sensor shown in Fig. 3. As shown in Fig. 21, each of the pixel circuits placed on the chip A includes a photodiode, a transfer transistor, a reset transistor, an amplification transistor, and a micro-bump. Further, each of the analog-to-digital converter circuits placed on the chip B includes a comparator, a counter and a micro-bump. The image sensor 15 according to the present invention is formed by bonding the chip A and the chip B together at the alternate long and short dashed line in Fig. 21 as the axis of symmetry. Further, the layout area of one analog-to-digital converter circuit formed on the chip B is set to be smaller than the layout area of one pixel circuit formed on the chip A. In this manner, by setting the layout area of one analog-to-digital converter circuit to be smaller than the layout area of one pixel circuit, it is possible to form, on the chip B, the number of analog-to-digital converter circuits which can convert the pixel signals (signals including the dark level signal and the imaging signal) respectively output from the pixel circuits arranged in a lattice structure into digital values all at once.

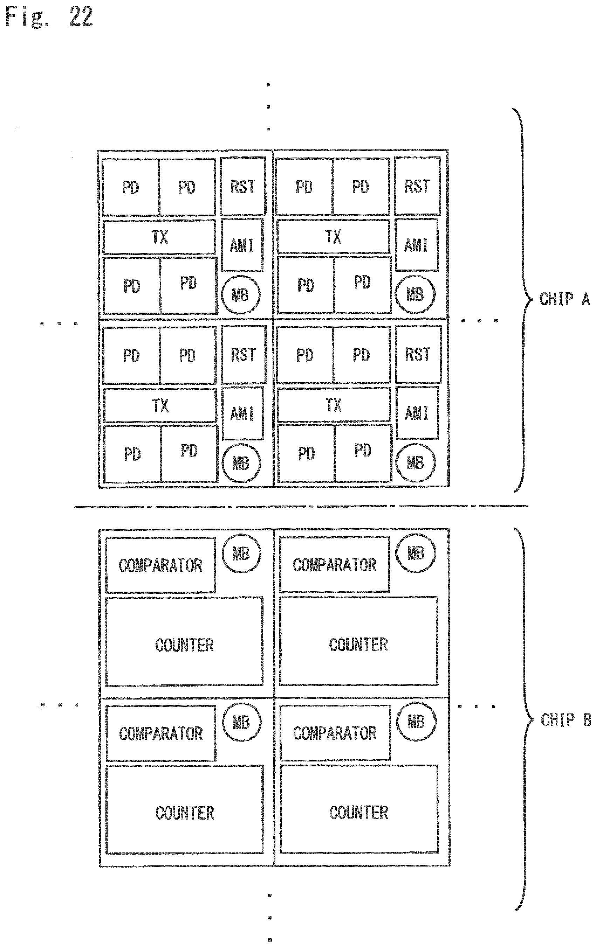

Further, Fig. 22 shows a layout example corresponding to the image sensor shown in Fig. 14. In the image sensor shown in Fig. 22, one pixel circuit includes four diodes and also includes one set of a transfer transistor, a reset transistor, an amplification transistor and a micro-bump. Further, in the example shown in Fig. 22, each of the analog-to-digital converter circuits placed on the chip B includes a comparator, a counter and a micro-bump. The image sensor 15 according to the present invention is formed by bonding the chip A and the chip B together at the alternate long and short dashed line in Fig. 22 as the axis of symmetry. In the example shown in Fig. 22, the layout area of one analog-to-digital converter circuit formed on the chip B is set to be smaller than the layout area of one pixel circuit formed on the chip A. In this manner, by setting the layout area of one analog-to-digital converter circuit to be smaller than the layout area of one pixel circuit, it is possible to form, on the chip B, the number of analog-to-digital converter circuits which can convert the pixel signals respectively output from the pixel circuits arranged in a lattice structure into digital values all at once in the image sensor shown in Fig. 14 as well.

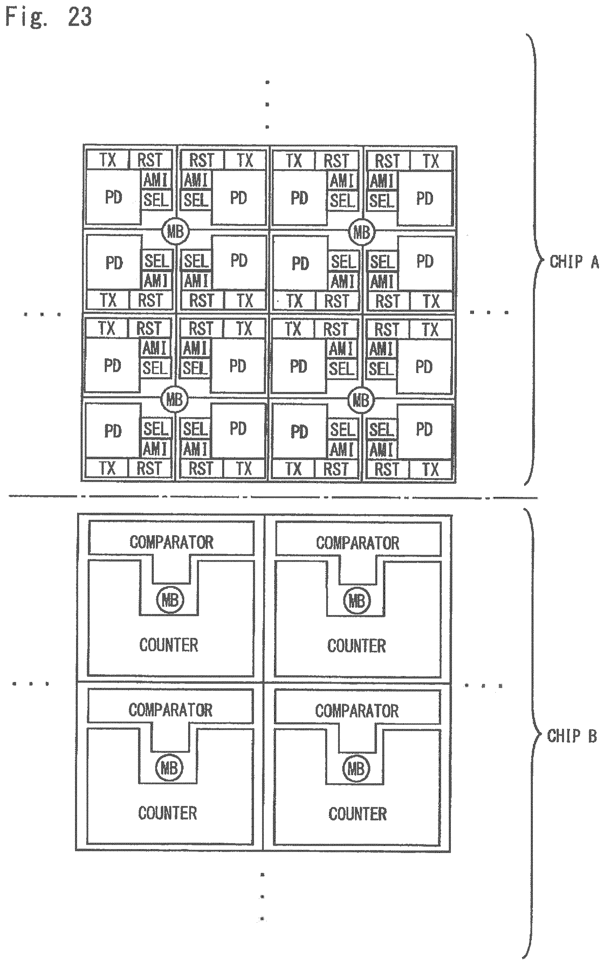

Further, Fig. 22 shows a layout example corresponding to the image sensor shown in Fig. 14. In the image sensor shown in Fig. 23, one micro-bump is placed for four pixel circuits. Further, in the example shown in Fig. 23, each of the analog-to-digital converter circuits placed on the chip B includes a comparator, a counter and a micro-bump. The image sensor 15 according to the present invention is formed by bonding the chip A and the chip B together at the alternate long and short dashed line in Fig. 23 as the axis of symmetry. In the example shown in Fig. 23, the layout area of one analog-to-digital converter circuit formed on the chip B is set to be smaller than the layout area of the pixel circuits connected to one micro-bump on the chip A. In this manner, by setting the layout area of one analog-to-digital converter circuit to be smaller than the layout area of the pixel circuits connected to one micro-bump, it is possible to form, on the chip B, the number of analog-to-digital converter circuits which can convert the pixel signals sequentially output from the pixel circuits arranged in a lattice structure into digital values all at once at each output timing in the image sensor shown in Fig. 19 as well.

Note that the examples shown in Fig. 21 to Fig. 23 are preferred examples of the layout of the image sensor 15 according to the present invention, and the actual layout method can be varied as appropriate. Further, Fig. 21 to Fig. 23 are presented merely for the purpose of illustrating the relationship of the layout area between the pixel circuits and the analog-to-digital converter circuits, and other circuits are also formed on the chip A and the chip B. Furthermore, although one way to make the number of analog-to-digital converter circuits closer to the number of pixel circuits is to form an analog-to-digital converter circuit for each of the pixel circuits on the chip A, this increases the circuit area of the pixel circuits, thus causing a problem that the size of the image sensor and the lens system cannot fit into a realistic size.

### Eighth exemplary embodiment

In an eighth exemplary embodiment, an image sensor which is an alternative form of the image sensor 15 according to the first exemplary embodiment is described. Note that, in the description of the eighth exemplary embodiment, the same elements as those in the first exemplary embodiment are denoted by the same reference symbols as in the first exemplary embodiment and the description thereof is omitted.

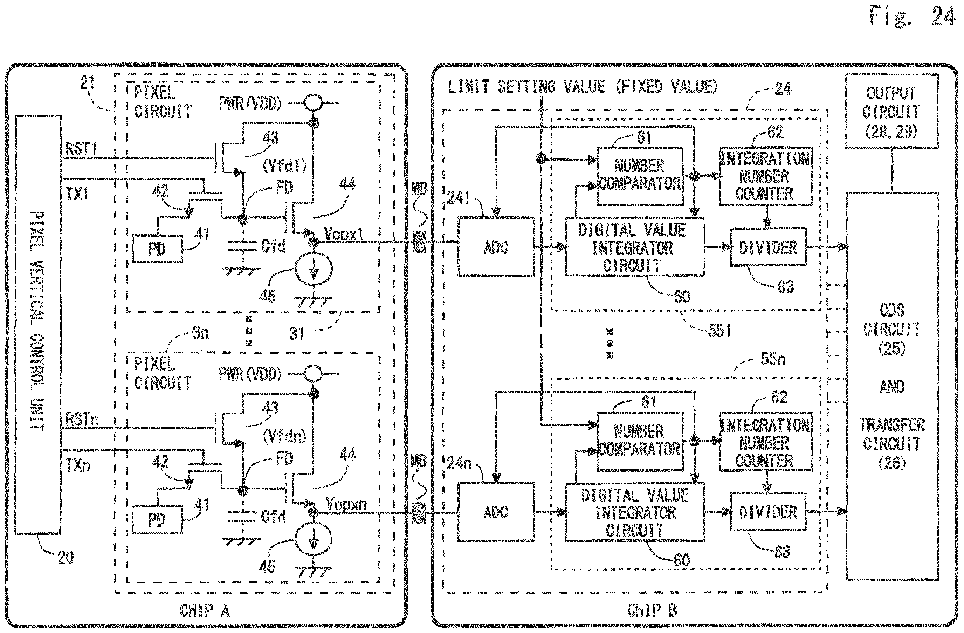

Fig. 24 is a block diagram of the image sensor according to the eighth exemplary embodiment. As shown in Fig. 24, in the image sensor according to the eighth exemplary embodiment, arithmetic mean processing circuits 551 to 55n are added to the analog-to-digital converter circuit 24. The arithmetic mean processing circuits 551 to 55n are placed corresponding to the individual analog-to-digital converter circuits 241 to 24n, respectively. Each time the output value (digital value) of the corresponding analog-to-digital converter circuit changes, each of the arithmetic mean processing circuits 551 to 55n integrates the changed output values to generate an integration output value, and outputs a value obtained by dividing the integration output value by the number of times of integration to a circuit placed in the subsequent stage.

For example, in the case where the individual analog-to-digital converter circuit 241 shown in Fig. 4 is used as the individual analog-to-digital converter circuit, the value of the counter 51, which is the output value of the individual analog-to-digital converter circuit 241, changes continuously until the comparative reference voltage falls below the voltage level of the pixel signal. Each time the output value of the individual analog-to-digital converter circuit 241 changes, the arithmetic mean processing circuits 551 to 55n integrate the output values. The number of times of integration is the number of times when the count value of the counter 51 changes. Thus, the arithmetic mean processing circuits 551 to 55n can output, as an arithmetic mean output value, a value obtained by dividing the integration output value by a different number of times of integration in accordance with the voltage level (e.g., the brightness of the pixel value) of the pixel signal.

Because the arithmetic mean processing circuits 551 to 55n have the same circuit structure, the arithmetic mean processing circuit is described by using the arithmetic mean processing circuit 551 as an example. The arithmetic mean processing circuit 551 includes a digital value integrator circuit 60, a number comparator 61, an integration number counter 62, and a divider 63.

Each time the output value (digital value) that is output from the individual analog-to-digital converter circuit 241 changes, the digital value integrator circuit 60 integrates the changed output values and generates an integration output value. The number comparator 61 compares a limit setting value that is preset as a fixed value and the number of times of integration performed in the digital value integrator circuit 60 (which is referred to hereinafter as the number of times of integration), and when the number of times of integration exceeds the limit setting value, instructs the digital value integrator circuit 60, the integration number counter 62 and the individual analog-to-digital converter circuit 241 to stop operating. The limit setting value is set to a number such that the count value of the integration number counter 62 does not overflow. Note that, in the case where the integration number counter 62 has a count upper limit that is high enough, the number comparator 61 may be eliminated.

The integration number counter 62 counts the number of times of integration in the digital value integrator circuit 60 and generates a count value. The divider 63 divides the integration output value that is output from the digital value integrator circuit 60 by the count value that is output from the integration number counter 62, and outputs an arithmetic mean output value to the subsequent circuit.

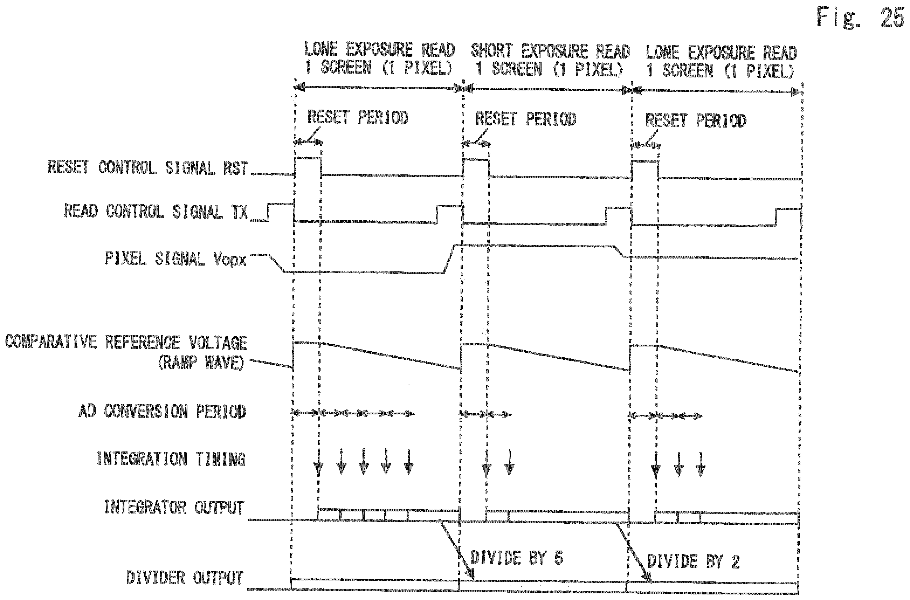

The operation of the image sensor according to the eighth exemplary embodiment is described hereinafter. Fig. 25 is the timing chart illustrating the operation of the image sensor according to the eighth exemplary embodiment. In the example shown in Fig. 25, the analog-to-digital converter circuit shown in Fig. 4 is used as the individual analog-to-digital converter circuit. Further, the example of Fig. 25 is related to the image sensor that carries out high-dynamic-range rendering that obtains one image by synthesizing a long exposure image where the clarity of a dark part of one image is enhanced by long exposure time and a short exposure image where the clarity of a bright part of one image is enhanced by short exposure time. This high-dynamic-range rendering process applies a high gain to the pixel signal obtained by long exposure and performs conversion into a digital value, and applies a smaller gain than the gain during long exposure to the pixel signal obtained by short exposure and performs conversion into a digital value after that. In a dark part of the image obtained by long exposure, the signal amplitude is insufficient even with a higher gain. In a bright part of the image obtained by short exposure, the signal amplitude is sufficient with a smaller gain.

As shown in Fig. 25, the image sensor according to the eighth exemplary embodiment initiates analog-to-digital conversion after the end of the reset period of the dark level signal, and integrates the digital output values of the individual analog-to-digital converter circuit 241 that change with a decrease in the comparative reference voltage. As shown in Fig. 25, the pixel signal in a dark part of the image obtained by long exposure tends to have an insufficient luminance and a low voltage level, and the pixel signal in a bright part of the image obtained by short exposure tends to have a sufficient luminance and a high voltage level. Therefore, the number of times of conversion performed by the individual analog-to-digital converter circuit 241 can be larger in the conversion process that is performed on the pixel signal obtained by long exposure than in the conversion process that is performed on the pixel signal obtained by short exposure.

Then, in the image sensor according to the eighth exemplary embodiment, the arithmetic mean output value (the output of the divider in Fig. 25) is output to the next stage at the next read timing. At this time, in the image sensor according to the eighth exemplary embodiment, the arithmetic mean output value is a value that is obtained by dividing the integration output value by the number of times of integration.

As described above, the image sensor according to the eighth exemplary embodiment performs arithmetic mean processing on the output value of the analog-to-digital converter circuit and then outputs the value to the circuit in the subsequent stage. It is thereby possible to reduce noise in the pixel values in the image sensor according to the eighth exemplary embodiment. To be more specific, when the number of times of integration is N, the noise level can be reduced to approximately 1/√N in the image sensor according to the eighth exemplary embodiment. When the conversion accuracy of the analog-to-digital converter circuit is 10 bits, N is 1024, and the noise level is reduced to 30 times smaller compared with the case of not performing arithmetic mean processing.

Further, in the image sensor according to the eighth exemplary embodiment, the number of times of integration increases as the voltage level of the pixel signal is lower (or the pixel value is darker). The high-dynamic-range rendering process that synthesizes images obtained by different exposure times, i.e., long exposure and short exposure, applies a high gain to a dark part. Therefore, in the high-dynamic-range rendering process, a noise level in a dark part tends to be high. However, in the image sensor according to the eighth exemplary embodiment, the number of times of integration is large for the pixel signal in the dark part, and it is thereby possible to enhance noise reduction capability. On the other hand, in the image sensor according to the eighth exemplary embodiment, there is no need to increase the number of times of integration for the pixel signal in the bright part obtained by short exposure, and it is thereby possible to suppress power consumption.

As described above, by varying the number of times of integration in accordance with the level of the pixel signal, it is possible to exhibit high noise reduction capability for the pixel signal in a dark part, and it is possible to reduce power consumption for the pixel signal in a bright part by suppressing the number of times of integration in the image sensor according to the eighth exemplary embodiment.

### Ninth exemplary embodiment

In a ninth exemplary embodiment, an image sensor which is an alternative form of the image sensor according to the eighth exemplary embodiment is described. Note that, in the description of the ninth exemplary embodiment, the same elements as those in the first and eighth exemplary embodiments are denoted by the same reference symbols as in the first and eighth exemplary embodiments and the description thereof is omitted.

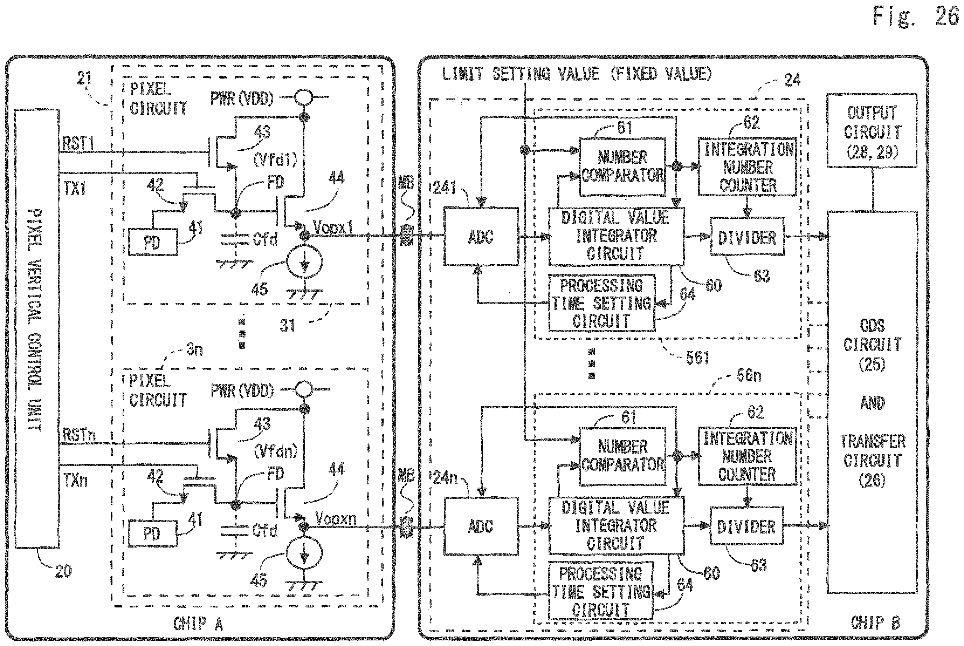

Fig. 26 is a block diagram of the image sensor according to the ninth exemplary embodiment. As shown in Fig. 26, in the image sensor according to the ninth exemplary embodiment, the arithmetic mean processing circuits 551 to 55n are replaced by arithmetic mean processing circuits 561 to 56n. The arithmetic mean processing circuits 561 to 56n have a structure in which a processing time setting circuit 64 is added to the arithmetic mean processing circuits 551 to 55n.

The processing time setting circuit 64 sets the length of the processing cycle period of the individual analog-to-digital converter circuit based on the output value obtained by the initial analog-to-digital conversion out of the analog-to-digital conversion that is performed repeatedly on one pixel signal by the individual analog-to-digital converter circuit. To be specific, as an initial value, the processing time setting circuit 64 has a conversion time corresponding to a bright part as the time needed for the first conversion that is performed on one pixel signal by the individual analog-to-digital converter circuit. Then, when the output value that is obtained by the initial analog-to-digital conversion corresponds to a bright part, the processing time setting circuit 64 does not change the length of the conversion cycle period. On the other hand, when the output value that is obtained by the initial analog-to-digital conversion corresponds to a dark part, the processing time setting circuit 64 changes the conversion cycle period to a shorter time.

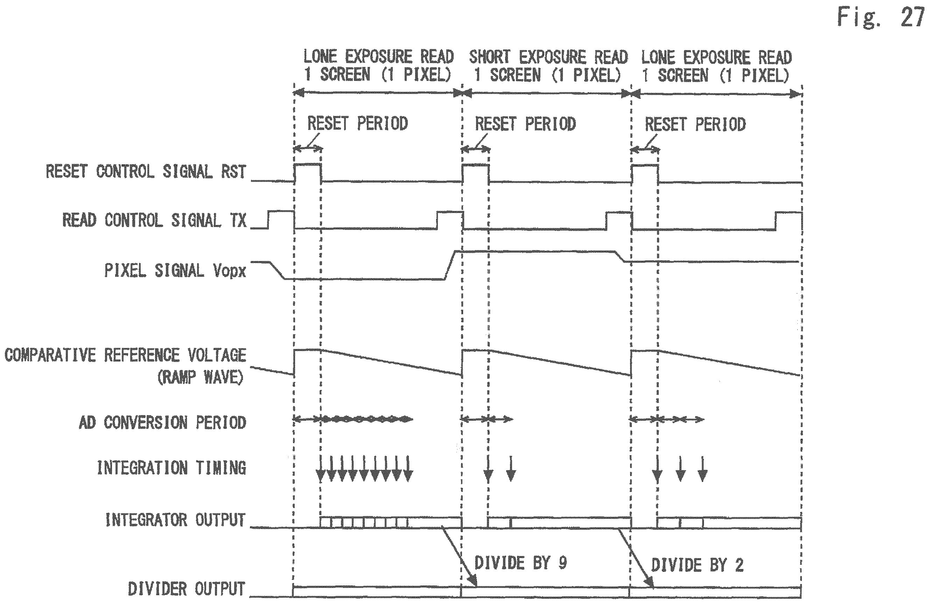

The operation of the image sensor according to the ninth exemplary embodiment is described hereinafter. Fig. 27 is a timing chart illustrating the operation of the image sensor according to the ninth exemplary embodiment. In the timing chart shown in Fig. 27, the same operation as the image sensor according to the eighth exemplary embodiment shown in Fig. 25 is performed by the image sensor according to the ninth exemplary embodiment. As shown in Fig. 27, in the image sensor according to the ninth exemplary embodiment, the conversion cycle period during which the pixel signal corresponding to a dark part is obtained is changed to be shorter.

As described above, in the image sensor according to the ninth exemplary embodiment, by reducing the conversion cycle period for the pixel signal corresponding to a dark part, it is possible to increase the number of times of integration to be performed in one period. In this manner, by increasing the number of times of integration on the pixel signal corresponding to a dark part, it is possible to achieve higher noise compression capability for the pixel signal corresponding to a dark part.

While the invention has been described in terms of several embodiments, those skilled in the art will recognize that the invention can be practiced with various modifications within the spirit and scope of the appended claims and the invention is not limited to the examples described above.

Further, the scope of the claims is not limited by the embodiments described above.

Furthermore, it is noted that, Applicant's intent is to encompass equivalents of all claim elements, even if amended later during prosecution.

The first to eighth embodiments can be combined as desirable by one of ordinary skill in the art.

It should be noted that the image sensor described in above exemplary embodiment includes those described in the following supplementary notes.

### (Supplementary Notes)

An image sensor comprising:
a first chip; and
a second chip configured to transmit and receive signals to and from the first chip through a micro-bump, the first chip being stacked on top of the second chip, wherein
on the first chip, pixel circuits are arranged in a lattice structure, each of the pixel circuits including
   a photoelectric conversion element,
   a floating diffusion,
   a transfer transistor placed between the photoelectric conversion element and the floating diffusion,
   a reset transistor configured to apply a reset voltage to the floating diffusion in accordance with a reset signal, and
   an amplification transistor configured to output a pixel signal based on a potential of the floating diffusion, and
on the second chip,
at least an analog-to-digital converter circuit configured to convert a voltage level of the pixel signal into a digital value is placed, and
a layout area of the analog-to-digital converter circuit is equal to or smaller than a layout area of the pixel circuits connected to one micro-bump.

## Claims

1. An image sensor comprising:
a first chip; and
a second chip configured to transmit and receive signals to and from the first chip through a micro-bump, the first chip being stacked on top of the second chip, wherein
on the first chip, pixel circuits are arranged in a lattice structure, each of the pixel circuits including
a photoelectric conversion element,
a floating diffusion,
a transfer transistor placed between the photoelectric conversion element and the floating diffusion,
a reset transistor configured to apply a reset voltage to the floating diffusion in accordance with a reset signal, and
an amplification transistor configured to output a pixel signal based on a potential of the floating diffusion, and
on the second chip,
at least an input stage circuit of a circuit configured to perform signal processing on the pixel signal is placed, and
two or more input stage circuits are placed for the pixel circuits arranged in one line.

2. The image sensor according to Claim 1, wherein the input stage circuit is an analog-to-digital converter circuit configured to generate a digital value corresponding to an analog level of the pixel signal.

3. The image sensor according to Claim 2, wherein a plurality of circuits in a subsequent stage of the analog-to-digital converter circuit are placed on the second chip.

4. The image sensor according to one of Claims 1 to 3, comprising:
a third chip configured to transmit and receive signals to and from the second chip through a micro-bump, the second chip being stacked on top of the third chip, wherein
at least the input stage circuit is placed on the second chip, and
circuits excluding the input stage circuit are formed on the third chip.

5. The image sensor according to one of Claims 1 to 4, wherein each of the pixel circuits includes a plurality of photoelectric conversion elements.

6. The image sensor according to Claim 5, wherein
the input stage circuit is an analog-to-digital converter circuit, and
the analog-to-digital converter circuit includes digital value holding circuits configured to hold a conversion result of the analog-to-digital converter circuit, the number of digital value holding circuits corresponding to the number of the plurality of photoelectric conversion elements.

7. The image sensor according to one of Claims 1 to 6, wherein the second chip includes a current source serving as a load of the amplification transistor.

8. The image sensor according to one of Claims 1 to 7, wherein each of the pixel circuits includes an output clamp transistor connected in parallel with the amplification transistor, a gate of the output clamp transistor being supplied with a clamp setting voltage.

9. The image sensor according to one of Claims 1 to 8, wherein a pixel power supply voltage applied to a drain of the amplification transistor and the reset voltage have different voltage values from each other.

10. The image sensor according to one of Claims 1 to 9, wherein one micro-bump is placed for the plurality of pixel circuits.

11. The image sensor according to one of Claims 2 to 10, wherein the second chip includes an arithmetic mean processing circuit configured to, each time an output value of the analog-to-digital converter circuit changes, perform an integration of the changed output value to generate an integration output value, and output an arithmetic mean output value to a circuit placed in a subsequent stage, the arithmetic mean output value being generated by dividing the integration output value by the number of times of integration.

12. The image sensor according to Claim 11, wherein the arithmetic mean processing circuit includes a processing time setting circuit configured to set a length of a processing cycle period of the analog-to-digital converter circuit based on the output value obtained by initial analog-to-digital conversion out of analog-to-digital conversion performed repeatedly on the one pixel signal by the analog-to-digital converter circuit.
